# EUROPEAN PATENT SPECIFICATION

(11) **EP 0 400 524 B1**
(45) Date of publication and mention of the grant of the patent: **17.08.1994**
(21) Application number: 90110057.8
(22) Date of filing: 28.05.1990
(51) Int. Cl.: H01L 39/24

(54) **Method for manufacturing superconducting article**
Methode zur Herstellung supraleitender Artikel
Méthode pour fabriquer des articles supraconducteurs

(30) Priority: 29.05.1989 JP 135110/89
(43) Date of publication of application: 05.12.1990
(73) Proprietor: NKK CORPORATION, Tokyo (JP)
(72) Inventor: Shinbo, Yukio, c/o NKK Corporation, Tokyo (JP); Ono, Moriaki, c/o NKK Corporation, Tokyo (JP); Kabasawa, Makoto, c/o NKK Corporation, Tokyo (JP); Kosuge, Shigeyoshi, c/o NKK Corporation, Tokyo (JP)
(74) Representative: Henkel, Feiler, Hänzel & Partner

(56) References cited:
- EP-A- 0 292 959
- EP-A- 0 310 332
- APPLIED PHYSICS LETTERS, vol. 52, no. 11, 14th March 1988, pages 924-926, new York, US; C. CHANG et al.: "Effects of silver and gold on the YBaCuO superconducting thin films with the use of Ag/Cu/BaO/Y2O3 and Au/Cu/BaO/Y2O3 structures"
- JAPANESE JOURNAL OF APPLIED PHYSICS, vol. 26, no. 9, September 1987, pages L1451-L1452, Tokyo, JP; Y. SORIMACHI: "Formation of superconducting Y-Ba-Cu-O thin films by the solid phase reaction between BaCO3/Cu/Y2O3 layers on single crystalline SrTiO3 substrate"

## Description

A method for manufacturing a superconducting article, comprising the steps of: forming a first layer comprising a mixture of LnBa₂Cu₃Oₓ and Ln₂BaCuOₓ on the surface of a substrate, said Ln being an optional rare earth element; then locally and sequentially heating and melting the first layer to locally and sequentially form a molten pool of the mixture of the first layer, and causing the molten pool of the first layer to locally and sequentially solidify, thereby arranging the a-b plane of the crystal of the mixture of the first layer in parallel with the surface of the substrate; then forming a second layer comprising a mixture of at least CuO and BaCuO₂ on the surface of the first layer; and then melting the mixture of the second layer to cause the resultant melt of the mixture of the second layer to diffusion-react with Ln₂BaCuOₓ in the first layer so as to convert the first and second layers into a film of a superconducting substance comprising LnBa₂Cu₃Oₓ, in which the a-b plane of the crystal thereof is arranged in parallel with the surface of the substrate; thereby manufacturing a superconducting article comprising the substrate and the film of the superconducting substance formed on the surface of the substrate.

### REFERENCE TO PATENTS, APPLICATIONS AND PUBLICATIONS PERTINENT TO THE INVENTION

As far as we know, there is available the following prior art document pertinent to the present invention:
"Japanese Journal of Applied Physics", Vol. 27, No. 8, pages L1501-L1503, published on July 22, 1988.

The contents of the prior art disclosed in the above-mentioned prior art document will be discussed hereafter under the heading of the "BACKGROUND OF THE INVENTION".

### FIELD OF THE INVENTION

The present invention relates to a method for manufacturing a superconducting article comprising a substrate and a film of a superconducting substance formed on the surface of the substrate.

### BACKGROUND OF THE INVENTION

Superconducting materials have already been practically applied in the form of a superconducting magnet in a particle accelerator, a medical diagnosing instrument and the like. Potential applications of the superconducting materials include an electric power generator, an energy storage, a linear motor car, a magnetic separator, a nuclear fusion reactor, a power transmission cable, and a magnetic shielder. In addition, a superconducting element using the Josephson effect is expected to be applied in such fields as an ultra-high speed computer, an infrared sensor and a low-noise amplifier. The magnitude of industrial and social impacts, which would exert upon practical realization of these applications, is really unmeasurable.

One of the typical superconducting materials so far developed is an Nb-Ti alloy which is widely used at present as a magnetizing wire. The Nb-Ti alloy has a critical temperature, i.e., a critical temperature from which a superconductive state occurs (hereinafter simply referred to as "Tc") of 9 K. As a superconducting material having a "Tc" considerably higher than that of the Nb-Ti alloy, a compound-type superconducting material has been developed, including an Nb₃Sn (Tc: 18 K) and V₃Ga (Tc: 15 K) which are now practically employed in the form of wire.

As a superconducting material having a "Tc" further higher than those of the above-mentioned alloy-type and compound-type superconducting materials, a composite oxide type superconducting material containing a CuₓO_{y}-radical has recently been developed. For example, a Y-Ba-Cu-O type superconducting material has a "Tc" of about 93 K. Since liquid nitrogen has a temperature of 77 K, liquid nitrogen available at a lower cost than liquid helium can be used as a cooling medium for the composite oxide type superconducting material. Development of a superconducting material having a high "Tc" applicable at a temperature of liquid nitrogen urges further expectations for the foregoing fields of application. In the actual application, however, problems are how to process a superconducting material in the form of a film or a wire, and at the same time, how to increase a critical current density (hereinafter simply referred to as "Jc") of the superconducting material.

In order to increase "Jc" of a superconducting material, it is necessary, when using the superconducting material in the form of a film, to make the structure of the film dense with a single superconducting phase.

A method for manufacturing a superconducting article, in which "Jc" of a film of a superconducting material can be increased by making the structure of the film of the superconducting material dense with a single superconducting phase, is disclosed in the "Japanese Journal of Applied Physics", Vol. 27, No.8, pages L1501-L1503, published on July 22, 1988 (hereinafter referred to as the "prior art"). The prior art is described below with reference to the drawings.

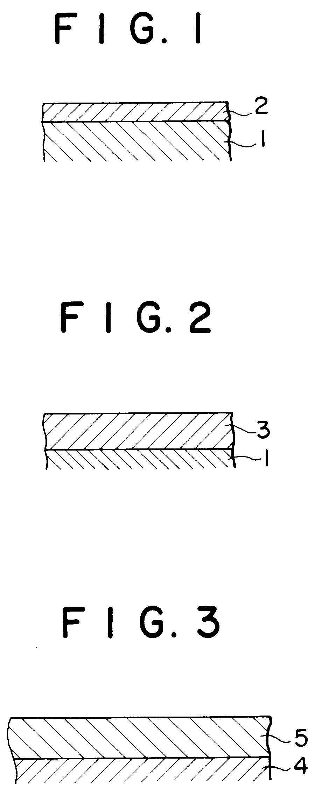

Fig. 1 is a schematic descriptive view illustrating the former half steps of the method of the prior art for manufacturing a superconducting article, and Fig. 2 is a schematic descriptive view illustrating the latter half steps of the method of the prior art for manufacturing the superconducting article.

First, a sheet-shaped substrate 1 comprising Y₂BaCuOₓ is prepared. Then, a mixture of CuO and BaCO₃, in which the ratio of copper (Cu) to barium (Ba) is Cu : Ba = 5 : 3 in molar ratio, is primary-fired at a temperature of 800°C for 24 hours, cooled, and pulverized into a powder. The powder of the thus primary-fired mixture is then secondary-fired at a temperature of 900°C for 24 hours, cooled, and pulverized into a powder to prepare a powdery material for a film. Subsequently, the thus prepared powdery material for a film is mixed with ethyl alcohol to prepare a slurry for a film.

Then, the thus prepared slurry for a film is applied onto the surface of the substrate 1, and dried to form a film 2 comprising Ba-Cu oxides on the surface of the substrate 1, as shown in Fig. 1.

Then, the substrate 1, on the surface of which the film 2 has thus been formed, is heated in an electric furnace to melt the film 2 to cause the resultant melt of the Ba-Cu oxides in the film 2 to diffusion-react with Y₂BaCuOₓ in the substrate 1, thereby converting the film 2 into a film 3 of a superconducting substance comprising YBa₂Cu₃Oₓ, as shown in Fig. 2.

Then, the film 3 of the superconducting substance thus produced is cooled to a room temperature, thereby manufacturing a superconducting article comprising a non-reacting substrate 1 and the film 3 of the superconducting substance formed on the surface of the non-reacting substrate 1, as shown in Fig. 2.

The above-mentioned prior art has the following effects: Since the film 3 of the superconducting substance comprising YBa₂Cu₃Oₓ is produced through the diffusion-reaction of the resultant melt of the Ba-Cu oxides in the film 2 with Y₂BaCuOₓ in the substrate 1, the structure of the film 3 of the superconducting substance is dense with a single superconducting phase, thus permitting manufacture of a superconducting article having a high "Jc".

However, the above-mentioned prior art has the following problems:
(1) When the film 3 of the superconducting substance comprising YBa₂Cu₃Oₓ is produced on the surface of the substrate 1 through the diffusion-reaction of the resultant melt of the Ba-Cu oxides in the film 2 with Y₂BaCuOₓ in the substrate 1, the film 3 of the superconducting substance expands in volume, causing cracks in the film 3 of the superconducting substance and resulting in seriously deteriorated superconducting properties of the superconducting article including a largely decreased "Jc".
(2) In order to further increase "Jc" of a superconducting article, it is necessary to arrange the a-b plane. of the crystal of the superconducting substance of the film 3 in parallel with the surface of the substrate 1. The reason is that the a-b plane of the crystal of the superconducting substance permits the easiest flow of electric current. According to the above-mentioned prior art, however, the a-b plane of the crystal of the superconducting substance of the film 3 shows diverse and various orientations.

The above-mentioned problems (1) and (2) occur also in the case where the film 3 of a superconducting substance is produced by means of a compound containing an optional rare earth element other than "yttrium" (Y) in the above-mentioned Y₂BaCuOₓ and YBa₂Cu₃Oₓ. Such an optional rare earth element is hereinafter represented by "Ln".

### SUMMARY OF THE INVENTION

An object of the present invention is therefore to provide a method for manufacturing a superconducting article, which permits prevention, when producing a film of a superconducting substance comprising LnBa₂Cu₃Oₓ on the surface of a substrate through the diffusion-reaction, of the occurrence of cracks in the film of the superconducting substance, and arrangement of the a-b plane of the crystal of the superconducting substance of the film in parallel with the surface of the substrate, and as a result allows manufacture of the superconducting article having excellent superconducting properties.

In accordance with one of the features of the present invention, there is provided a method for manufacturing a superconducting article, characterized by the steps of:
forming a first layer comprising a mixture of LnBa₂Cu₃Oₓ and Ln₂BaCuOₓ on the surface of a substrate, said Ln being an optional rare earth element, and the content ratio of said Ln₂BaCuOₓ in said first layer being within the range of from 5 to 80 wt.% relative to the total amount of LnBa₂Cu₃Oₓ and Ln₂BaCuOₓ; then
locally and sequantially heating and melting said first layer to locally and sequentially form a molten pool of said mixture of said first layer, and causing said molten pool of said first layer to locally and sequentially solidify, thereby arranging the a-b plane of the crystal of said mixture of said first layer in parallel with the surface of said substrate; then
forming a second layer comprising a mixture of at least CuO and BaCuO₂ on the surface of said first layer, said second layer having a melting point within the range of from 800 to 1,000°C, which is lower than the melting point of said first layer; then
melting said mixture of said second layer, and keeping the molten state of said second layer for a period of time of from 1 minute to 4 hours in an oxygen-containing atmosphere to cause the resultant melt of said mixture of said second layer to diffusion-react with Ln₂BaCuOₓ in said first layer, thereby converting said first layer and said second layer into a film of a superconducting substance comprising LnBa₂Cu₃Oₓ, in which the a-b plane of the crystal thereof is arranged in parallel with the surface of said substrate; and then
cooling said film of said superconducting substance thus produced to a room teperature, thereby manufacturing a superconducting article comprising said substrate and said film of said superconducting substance formed on the surface of said substrate.

### BRIEF DESCRIPTION OF THE DRAWINGS

Fig. 1 is a schematic descriptive view illustrating the former half steps in the method of the prior art for manufacturing a superconducting article;
Fig. 2 is a schematic descriptive view illustrating the latter half steps in the method of the prior art for manufacturing the superconducting article;
Fig. 3 is a schematic descriptive view illustrating a first step in an embodiment of the method of the present invention for manufacturing a superconducting article;
Fig. 4 is a schematic descriptive view illustrating a second step in the embodiment of the method of the present invention for manufacturing the superconducting article;
Fig. 5 is a schematic descriptive view illustrating a third step in the embodiment of the method of the present invention for manufacturing the superconducting article; and
Fig. 6 is a schematic descriptive view illustrating a fourth step in the embodiment of the method of the present invention for manufacturing the superconducting article.

### DETAILED DESCRIPTION OF PREFERRED EMBODIMENTS

From the above-mentioned point of view, extensive studies were carried out to develop a method for manufacturing a superconducting article, which permits prevention, when producing a film of a superconducting substance comprising LnBa₂Cu₃Oₓ on the surface of a substrate through the diffusion-reaction, of the occurrence of cracks in the film of the superconducting substance, and arrangement of the a-b plane of the crystal of the superconducting substance of the film in parallel with the surface of the substrate, and as a result allows manufacture of the superconducting article having excellent superconducting properties.

As a result, the following findings were obtained:
(1) Cracks occur in the film of the superconducting substance comprising LnBa₂Cu₃Oₓ because the film of the superconducting substance expands in volume when the film of the superconducting substance comprising LnBa₂Cu₃Oₓ is produced on the surface of the substrate through the diffusion-reaction. Crack can therefore be prevented from occurring in the film of the superconducting substance comprising LnBa₂Cu₃Oₓ, by reducing the amount of LnBa₂Cu₃Oₓ produced through the diffusion-reaction to reduce the amount of expansion in volume of the film of the superconducting substance comprising LnBa₂Cu₃Oₓ.
(2) It is possible to arrange the a-b plane of the crystal of the film of a superconducting substance comprising LnBa₂Cu₃Oₓ in parallel with the surface of the substrate by locally and sequentially heating and melting the film, formed on the surface of a substrate, comprising a mixture of LnBa₂Cu₃Oₓ and Ln₂BaCuOₓ, to locally and sequentially form a molten pool of the mixture of the film, and causing the molten pool to locally and sequentially solidify.

The present invention was made on the basis of the above-mentioned findings (1) and (2). Now, an embodiment of the method of the present invention for manufacturing a superconducting article is described below with reference to the drawings.

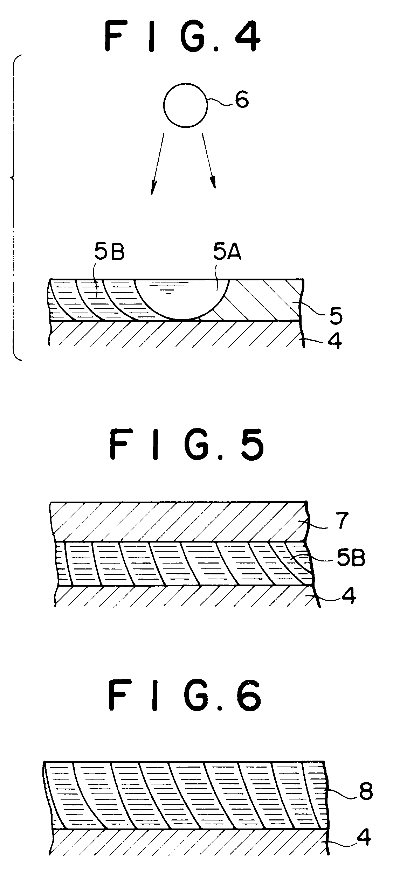

Fig. 3 is a schematic descriptive view illustrating a first step in an embodiment of the method of the present invention for manufacturing a superconducting article; Fig. 4 is a schematic descriptive view illustrating a second step in the embodiment of the method of the present invention for manufacturing the superconducting article; Fig. 5 is a schematic descriptive view illustrating a third step in the embodiment of the method of the present invention for manufacturing the superconducting article; and Fig. 6 is a schematic descriptive view illustrating a fourth step in the embodiment of the method of the present invention for manufacturing the superconducting article.

In the embodiment of the method of the present invention for manufacturing a superconducting article, a first layer 5 comprising a mixture of LnBa₂Cu₃Oₓ and Ln₂BaCuOₓ is formed in the first place on the surface of a substrate 4, as shown in Fig. 3, by means of the known plasma metallizing method or the like. The substrate 4 comprises any one of ceramics, silver, nickel and a nickel-based alloy, which hardly react with a superconducting substance comprising LnBa₂Cu₃Oₓ The content ratio of Ln₂BaCuOₓ in the first layer 5 should be within the range of from 5 to 80 wt.% relative to the total amount of LnBa₂Cu₃Oₓ and Ln₂BaCuOₓ.

The content ratio of Ln₂BaCuOₓ in the first layer 5 is limited within the above-mentioned range for the following reason: With a content ratio of Ln₂BaCuOₓ of under 5 wt.%, the amount of Ln₂BaCuOₓ in the first layer is insufficient relative to the amount of a mixture of a second layer described later, so that a non-reacting fraction of the mixture of the second layer remains in a film described later of a superconducting substance comprising LnBa₂Cu₃Oₓ, which film is to be formed on the surface of the substrate 4, thus causing deterioration of superconducting properties of the film of the superconducting substance. With a content ratio of Ln₂BaCuOₓ of over 80 wt.%, on the other hand, the excessive amount of Ln₂BaCuOₓ makes it impossible to prevent cracks from occurring in the film of the superconducting substance comprising LnBa₂Cu₃Oₓ, which cracks are caused by the expansion in volume of the film during formation thereof.

Then, as shown in Fig. 4, a heater 6 using a laser beam or an electric resistance heat is installed above the substrate 4. The first layer 5 is locally and sequentially heated and melted by continuously moving the heater 6 in parallel with the surface of the substrate 4, thereby locally and sequentially forming a molten pool 5A of the above-mentioned mixture of the first layer 5, and the thus formed molten pool 5A of the mixture of the first layer 5 is caused to locally and sequentially solidify. With the progress of solidification of the molten pool 5A, Ln₂BaCuOₓ and LnBa₂Cu₃Oₓ are recrystallized. The a-b plane of the crystal of the thus recrystallized Ln₂BaCuOₓ and LnBa₂Cu₃Oₓ grows in parallel with the surface of the substrate 4 along with the progress of solidification of the molten pool 5A. As a result, a reformed first layer 5B is formed, which comprises a mixture of Ln₂BaCuOₓ and LnBa₂Cu₃Oₓ, in which the a-b plane of the crystal permitting the easiest flow of electric current is arranged in parallel with the surface of the substrate 4, on the surface of the substrate 4. In place of continuously moving the heater 6 in parallel with the surface of the substrate 4, the substrate 4 may be continuously moved in parallel with the heater 6.

Then, as shown in Fig. 5, a second layer 7 having a melting point within the range of from 800 to 1,000°C is formed by means of the known plasma metallizing method on the surface of the reformed first layer 5B. The second layer 7 comprises a mixture of at least CuO and BaCuO₂. A typical second layer 7 comprises a mixture of CuO, BaCuO₂ and BaO. In this case, the ratio of copper (Cu) to barium (Ba) in the second layer 7 should be within the range of Cu : Ba = 1 : 0.10 to 0.95 in molar ratio. Another example of the second layer 7 comprises a mixture of CuO, BaCuO₂, BaO, Y₂O₃ and YBa₂Cu₃O₇. In this case, the ratio of copper (Cu) to barium (Ba) and yttrium (Y) in the second layer 7 should be within the range of Cu : Ba : Y = 1 : 0.10 to 0.95 : 0.001 to 0.330 in molar ratio. Any of these mixtures of the second layer 7 diffusion-reacts with Ln₂BaCuOₓ in the reformed first layer 5B, and as a result, the reformed first layer 5B and the second layer 7 are converted into a film of a superconducting substance comprising LnBa₂Cu₃Oₓ, as described below.

Then, the mixture of the second layer 7 is melted, and the molten state of the second layer 7 is kept for a period of time of from 1 minute to 4 hours in an oxygen-containing atmosphere to cause the resultant melt of the mixture comprising at least CuO and BaCuO₂ of the second layer 7 to diffusion-react with Ln₂BaCuOₓ in the reformed first layer 5B, thereby converting the reformed first layer 5B and the second layer 7 into a film 8 of a superconducting substance comprising LnBa₂Cu₃Oₓ, as shown in Fig. 6. The arrangement of the a-b plane of the crystal of the mixture comprising Ln₂BaCuOₓ and LnBa₂Cu₃Oₓ of the reformed first layer 5B is never transformed even by the above-mentioned diffusion-reaction. Therefore, there is formed, on the surface of the substrate 4, the film 8 of the superconducting substance comprising LnBa₂Cu₃Oₓ, in which the a-b plane of the crystal is arranged in parallel with the surface of the substrate 4.

The period of time of keeping the molten state of the second layer 7 is limited within the range of from 1 minute to 4 hours for the following reason: With a period of time of molten state of the second layer 7 of under 1 minute, the resultant melt of the mixture of the second layer 7 cannot be caused to sufficiently diffusion-react with Ln₂BaCuOₓ in the reformed first layer 5B. With a period of time of molten state of the second layer 7 of over 4 hours, on the other hand, conversion of the reformed first layer 5B and the second layer 7 into the film 8 of the superconducting substance comprising LnBa₂Cu₃Oₓ does not progress further.

The thus produced film 8 of the superconducting substance is then cooled to a room temperature, thereby manufacturing a superconducting article comprising, as shown in Fig. 6, the substrate 4 and the film 8 of the superconducting substance formed on the surface of the substrate 4.

According to the embodiment of the method of the present invention for manufacturing a superconducting article, as described above, the reformed first layer 5B previously contains LnBa₂Cu₃Oₓ in a prescribed amount, and this reduces the amount of LnBa₂Cu₃Oₓ produced through the diffusion-reaction of the melt of the mixture of the second layer 7 with Ln₂BaCuOₓ in the reformed first layer 5B. As a result, the amount of expansion in volume of the film 8 of the superconducting substance comprising LnBa₂Cu₃Oₓ is reduced, thus preventing cracks from occurring in the film 8 of the superconducting substance. In addition, since the a-b plane of the crystal of the superconducting substance comprising LnBa₂Cu₃Oₓ of the film 8 formed on the surface of the substrate 4 is arranged in parallel with the surface of the substrate 4, it is possible to manufacture a superconducting article having a very high "Jc".

Now, the method of the present invention for manufacturing a superconducting article is described in more detail by means of examples with reference to Figs. 3 to 6.

### EXAMPLE 1

A mixture comprising CuO, BaCO₃ and Y₂O₃, in which the ratio of copper (Cu) to barium (Ba) and yttrium (Y) was Cu : Ba : Y = 2 : 1.5 : 1.5 in molar ratio, was primary-fired at a temperature of 900°C for 10 hours, cooled and pulverized into a powder. The powder of the thus primary-fired mixture was then secondary-fired at a temperature of 920°C for 10 hours, cooled and pulverized into a powder. The powder of the thus secondary-fired mixture was then tertiary-fired at a temperature of 950°C for 10 hours, cooled and pulverized into a powder to prepare a powdery material for first layer, having an average particle size within the range of from 26 to 44 µm. The thus prepared powdery material for first layer comprised a mixture of YBa₂Cu₃Oₓ and Y₂BaCuOₓ, and the content ratio of Y₂BaCuOₓ in the powdery material for first layer was 40 wt.% relative to the total amount of YBa₂Cu₃Oₓ and Y₂BaCuOₓ.

On the other hand, a mixture comprising CuO and BaCO₃, in which the ratio of copper (Cu) to barium (Ba) was Cu : Ba = 2 : 1 in molar ratio, was primary-fired at a temperature of 900°C for 10 hours, cooled and pulverized into a powder. The powder of the thus primary-fired mixture was then secondary-fired at a temperature of 920°C for 10 hours, cooled and pulverized into a powder. The powder of the thus secondary-fired mixture was then tertiary-fired at a temperature of 950°C for 30 minutes, cooled and pulverized into a powder to prepare a powdery material for second layer, having an average particle size within the range of from 26 to 44 µm. The thus prepared powdery material for second layer comprised a mixture of CuO, BaCuO₂ and BaO.

Then, the powdery material for first layer prepared as described above was blown by means of the known plasma metallizing method onto the surface of a substrate 4 comprising a nickel-based alloy and having a surface area of 1 cm² and a thickness of 1 mm, to form a first layer 5 having a thickness of 50 µm on the surface of the substrate 4, as shown in Fig. 3.

Then, as shown in Fig. 4, a heater 6 comprising a laser beam source having an output of 0.5 kW was installed above the substrate 4, and the heater 6 was continuously and horizontally moved in parallel with the surface of the substrate 4 at a speed of 1 m/minute while irradiating a laser beam from the heater 6 onto the first layer formed on the surface of the substrate 4. As a result, the first layer 5 was locally and sequentially heated and melted to locally and sequentially form a molten pool 5A of the mixture comprising YBa₂Cu₃Oₓ and Y₂BaCuOₓ of the first layer 5 on the surface of the substrate 4, and the thus formed molten pool 5A of the above-mentioned mixture of the first layer 5 was locally and sequentially solidified. Consequently, a reformed first layer 5B comprising the above-mentioned mxiture, in which the a-b plane of the crystal permitting the easiest flow of electric current was arranged in parallel with the surface of the substrate 4, was formed on the surface of the substrate 4.

Then, the powdery material for second layer prepared as described above was blown by means of the known plasma metallizing method onto the surface of the reformed first layer 5B, to form a second layer 7 having a thickness of 50 µm on the surface of the reformed first layer 5B, as shown in Fig. 5.

Then, the substrate 4, on the surface of which the reformed first layer 5B and the second layer 7 were thus formed, was heated to a temperature of 950°C in an electric furnace having an interior atmosphere of air to melt the second layer 7, and the molten state of the second layer 7 was kept for 30 minutes. This permitted the diffusion-reaction of the resultant melt of the mixture comprising CuO, BaCuO₂ and BaO of the second layer 7 with Y₂BaCuOₓ in the reformed first layer 5B, whereby the reformed first layer 5B and the second layer 7 were converted into a film 8 of a superconducting substance comprising YBa₂Cu₃Oₓ having a thickness of 70 µm, as shown in Fig. 6.

The substrate 4, on the surface of which the film 8 of the superconducting substance was thus produced, was slowly cooled in the electric furnace to a room temperature.

Thus, a superconducting article was manufactured, which comprised the substrate 4 comprising a nickel-based alloy and the film 8 of the superconducting substance comprising YBa₂Cu₃Oₓ, the a-b plane of the crystal of which was arranged in parallel with the surface of the substrate 4, formed on the surface of the substrate 4, as shown in Fig. 6.

Investigation of the thus manufactured superconducting article revealed that the structure of the film 8 of the superconducting substance was dense with a single superconducting phase, and the superconducting article had a "Jc" of 3,200 A/cm².

### EXAMPLE 2

A mixture comprising CuO, BaCO₃ and Y₂O₃, in which the ratio of copper (Cu) to barium (Ba) and yttrium (Y) was Cu : Ba : Y = 2.4 : 1.7 : 1.3 in molar ratio, was primary-fired at a temperature of 900°C for 10 hours, cooled and pulverized into a powder. The powder of the thus primary-fired mixture was then secondary-fired at a temperature of 920°C for 10 hours, cooled and pulverized into a powder. The powder of the thus secondary-fired mixture was then tertiary-fired at a temperature of 950°C for 10 hours, cooled and pulverized into a powder to prepare a powdery material for first layer, having an average particle size within the range of from 26 to 44 µm. The thus prepared powdery material for first layer comprised a mixture of YBa₂Cu₃Oₓ and Y₂BaCuOₓ, and the content ratio of Y₂BaCuOₓ in the powdery material for first layer was 25 wt.% relative to the total amount of YBa₂Cu₃Oₓ and Y₂BaCuOₓ.

On the other hand, a mixture comprising CuO, BaCO₃ and Y₂O₃, in which the ratio of copper (Cu) to barium (Ba) and yttrium (Y) was Cu : Ba : Y = 26 : 13 : 1 in molar ratio, was primary-fired at a temperature of 900°C for 10 hours, cooled and pulverized into a powder. The powder of the thus primary-fired mixture was then secondary-fired at a temperature of 920°C for 10 hours, cooled and pulverized into a powder. The powder of the thus secondary-fired mixture was then tertiary-fired at a temperature of 950°C for 30 minutes, cooled and pulverized into a powder to prepare a powdery material for second layer, having an average particle size within the range of from 26 to 44 µm. The thus prepared powdery material for second layer comprised a mixture of CuO, BaCuO₂, BaO, Y₂O₃ and YBa₂Cu₃O₇.

Then, the powdery material for first layer prepared as described above was blown by means of the known plasma metallizing method onto the surface of a substrate 4 comprising a nickel-based alloy and having a surface area of 1 cm² and a thickness of 1 mm, to form a first layer 5 having a thickness of 50 µm on the surface of the substrate 4, as shown in Fig. 3.

Then, as shown in Fig. 4, a heater 6 comprising a laser beam source having an output of 0.5 KW was installed above the substrate 4, and the heater 6 was continously and horizontally moved in parallel with the surface of the substrate 4 at a speed of 1 m/minute while irradiating a laser beam from the heater 6 onto the first layer 5 formed on the surface of the substrate 4. As a result, the first layer 5 was locally and sequentially heated and melted to locally and sequentially form a molten pool 5A of the mixture comprising YBa₂Cu₃Oₓ and Y₂BaCuOₓ of the first layer 5 on the surface of the substrate 4, and the thus formed molten pool 5A of the above-mentioned mixture of the first layer 5 was locally and sequentially solidified. Consequently, a reformed first layer 5B comprising the above-mentioned mixture, in which the a-b plane of the crystal permitting the easiest flow of electric current was arranged in parallel with the surface of the substrate 4, was formed on the surface of the substrate 4.

Then, the powdery material for second layer prepared as described above was blown by means of the known plasma metallizing method onto the surface of the reformed first layer 5B, to form a second layer 7 having a thickness of 50 µm on the surface of the reformed first layer 5B, as shown in Fig. 5.

Then, the substrate 4, on the surface of which the reformed first layer 5B and the second layer 7 were thus formed, was heated to a temperature of 950°C in an electric furnace having an interior atmosphere of air to melt the second layer 7, and the molten state of the second layer 7 was kept for 30 minutes. This permitted the diffusion-reaction of the resultant melt of the mixute comprising CuO, BaCuO₂, BaO, Y₂O₃ and YBa₂Cu₃O₇ of the second layer 7 with Y₂BaCuOₓ in the reformed first layer 5B, whereby the reformed first layer 5B and the second layer 7 were converted into a film 8 of a superconducting substance comprising YBa₂Cu₃Oₓ having a thickness of 70 µm, as shown in Fig. 6.

Then, the substrate 4, on the surface of which the film 8 of the superconducting substance was thus produced, was slowly cooled in the electric furnace to a room temperature.

Thus, a superconducting article was manufactured, which comprised the substrate 4 comprising a nickel-based alloy and the film 8 of the superconducting substance comprising YBa₂Cu₃Oₓ, the a-b plane of the crystal of which was arranged in parallel with the surface of the substrate 4, formed on the surface of the substrate 4, as shown in Fig. 6.

Investigation of the thus manufactured superconducting article revealed that the structure of the film 8 of the superconducting substance was dense with a single superconducting phase, and the superconducting article had a "Jc" of 3,300 A/cm².

According to the method of the present invention, as described above in detail, it is possible to manufacture a superconducting article having excellent superconducting properties, in which, when a film of a superconducting substance comprising LnBa₂Cu₃Oₓ is produced on the surface of a substrate through the diffusion-reaction, cracks are prevented from occurring in the film of the superconducting substance, and the a-b plane of the crystal of the superconducting substance of the film is arranged in parallel with the surface of the substrate, thus providing industrially useful effects.

## Claims

1. A method to manufacture a superconducting article, characterized by the steps of:
forming a first layer comprising a mixture of LnBa₂Cu₃Oₓ and Ln₂BaCuOₓ on the surface of a substrate, said Ln being an optional rare earth element, and the content ratio of said Ln₂BaCuOₓ in said first layer being within the range of from 5 to 80 wt.% relative to the total amount of LnBa₂Cu₃Oₓ and Ln₂BaCuOₓ; then
locally and sequentially heating and melting said first layer to locally and sequentially form a molten pool of said mixture of said first layer, and causing said molten pool of said first layer to locally and sequentially solidify, thereby arranging the a-b plane of the crystal of said mixture of said first layer in parallel with the surface of said substrate; then
forming a second layer comprising a mixture of at least CuO and BaCuO₂ on the surface of said first layer, said second layer having a melting point within the range of from 800 to 1,000°C, which is lower than the melting point of said first layer; then
melting said mixture of said second layer, and keeping the molten state of said second layer for a period of time of from 1 minute to 4 hours in an oxygen-containing atmosphere to cause the resultant melt of said mixture of said second layer to diffusion-react with Ln₂BaCuOₓ in said first layer, thereby converting said first layer and said second layer into a film of a superconducting substance comprising LnBa₂Cu₃Oₓ, in which the a-b plane of the crystal thereof is arranged in parallel with the surface of said substrate; and then
cooling said film of said superconducting substance thus produced to a room temperature, thereby manufacturing a superconducting article comprising said substrate and said film of said superconducting substance formed on the surface of said substrate.

2. The method as claimed in Claim 1, wherein:
said substrate comprises any one of ceramics, silver, nickel and nickel-based alloy.

3. The method as claimed in Claim 1 or 2, wherein:
said second layer comprises a mixture of CuO, BaCuO₂ and BaO; and
the ratio of copper (Cu) to barium (Ba) in said second layer is within the range of Cu : Ba = 1 : 0.10 to 0.95 in molar ratio.

4. The method as claimed in Claim 1 or 2, wherein: said second layer comprises a mixture of CuO, BaCuO₂, BaO, Y₂O₃ and YBa₂Cu₃O₇; and
the ratio of copper (Cu) to barium (Ba) and yttrium (Y) in said second layer is within the range of Cu : Ba : Y = 1 : 0.10 to 0.95 : 0.001 to 0.330 in molar ratio.

## Patentansprüche

1. Verfahren zur Herstellung eines supraleitenden Formlings, gekennzeichnet durch die folgenden Schritte:
Ausbilden einer ein Gemisch aus LnBa₂Cu₃Oₓ und Ln₂BaCuOₓ umfassenden ersten Schicht auf der Oberfläche eines Substrats, wobei Ln für ein beliebiges Seltenerdeelement steht und wobei der Anteil an Ln₂BaCuOₓ in der ersten Schicht im Bereich von 5 - 80 Gew.-%, bezogen auf die Gesamtmenge an LnBa₂Cu₃Oₓ und Ln₂BaCuOₓ, liegt,
lokales und aufeinanderfolgendes Erwärmen und Erschmelzen der ersten Schicht zur lokalen und aufeinanderfolgenden Bildung eines Schmelzebades des Gemischs der ersten Schicht und lokales und aufeinanderfolgendes Verfestigenlassen des Schmelzebades der ersten Schicht, um die a-b-Kristallebene des Gemischs der ersten Schicht mit der Oberfläche des Substrats parallel auszurichten;
Ausbilden einer ein Gemisch aus mindestens CuO und BaCuO₂ umfassenden zweiten Schicht auf der Oberfläche der ersten Schicht, wobei die zweite Schicht einen Schmelzpunkt im Bereich von 800 - 1000°C, der unter dem Schmelzpunkt der ersten Schicht liegt, aufweist,
Erschmelzen des Gemischs der zweiten Schicht und 1-minütiges bis 4-stündiges Aufrechterhalten des erschmolzenen Zustandes der zweiten Schicht in einer sauerstoffhaltigen Atmosphäre zur Herbeiführung einer Diffusionsreaktion des erschmolzenen Gemischs der zweiten Schicht mit Ln₂BaCuOₓ in der ersten Schicht, um die erste Schicht und die zweite Schicht zu einem Film einer LnBa₂Cu₃Oₓ umfassenden supraleitenden Substanz, in der die a-b-Kristallebene parallel zu der Oberfläche des Substrats angeordnet ist, umzuwandeln und
anschließendes Kühlen des so hergestellten Films der supraleitenden Substanz auf Raumtemperatur, um einen das Substrat und den auf der Oberfläche des Substrats ausgebildeten Film der supraleitenden Substanz umfassenden supraleitenden Formling herzustellen.

2. Verfahren nach Anspruch 1, wobei das Substrat einen der Stoffe Keramiken, Silber, Nickel Und Legierung auf Nickelbasis umfaßt.

3. Verfahren nach Anspruch 1 oder 2, wobei die zweite Schicht ein Gemisch aus CuO, BaCuO₂ und BaO umfaßt und das Molverhältnis Kupfer(Cu)/Barium(Ba) in der zweiten Schicht im Bereich Cu/Ba = 1/0,10 bis 0,95 liegt.

4. Verfahren nach Anspruch 1 oder 2, wobei die zweite Schicht ein Gemisch von CuO, BaCuO₂, BaO, Y₂O₃ und YBa₂Cu₃O₇ umfaßt und das Molverhältnis von Kupfer(Cu)/Barium(Ba)/Yttrium(Y) in der zweiten Schicht im Bereich von Cu/Ba/Y = 1/0,10 bis 0,95/0,001 bis 0,330 liegt.

## Revendications

1. Un procédé pour fabriquer un article supraconducteur, caractérisé par les phases consistant à :
former une première couche comportant un mélange de LnBa₂Cu₃Oₓ et Ln₂BaCuOₓ sur la surface d'un substrat, Ln étant un élément de terre rare choisi et la teneur en Ln₂BaCuOₓ dans ladite première couche étant située dans la plage de 5 à 80 % en poids par rapport à la quantité totale de LnBa₂Cu₃Oₓ et Ln₂BaCuOₓ ; puis
chauffer et faire fondre localement et séquentiellement ladite première couche pour former localement et séquentiellement un bain fondu dudit mélange de ladite première couche, et provoquer localement et séquentiellement la solidification dudit bain fondu de ladite première couche, pour agencer ainsi le plan a-b du cristal dudit mélange de ladite première couche parallèlement à la surface dudit substrat ; puis
former une seconde couche comportant un mélange d'au moins CuO et BaCuO₂ sur la surface de ladite première couche, ladite seconde couche présentant un point de fusion situé dans la plage de 800 à 1.000°C, qui est inférieur au point de fusion de ladite première couche ; puis
faire fondre ledit mélange de ladite seconde couche, et maintenir l'état fondu de ladite seconde couche pendant une durée de 1 minute à 4 heures dans une atmosphère contenant de l'oxygène pour amener le produit fondu résultant dudit mélange de ladite seconde couche à réagir par diffusion avec Ln₂BaCuOₓ dans ladite première couche, de manière à convertir ainsi ladite première couche et ladite seconde couche en une pellicule d'une substance supraconductrice comportant LnBa₂Cu₃Oₓ , dans laquelle le plan a-b de son cristal est agencé parallèlement à la surface dudit substrat; puis
refroidir ladite pellicule de ladite substance supraconductrice ainsi produite à la température ambiante, de manière à fabriquer ainsi un article supraconducteur comportant ledit substrat et ladite pellicule de ladite substance supraconductrice formée sur la surface dudit substrat.

2. Le procédé tel que revendiqué dans la revendication 1, dans lequel :
ledit substrat comporte l'un quelconque des éléments constitués par une céramique, de l'argent, du nickel ou un alliage à base de nickel.

3. Le procédé tel que revendiqué dans la revendication 1 ou 2, dans lequel :
ladite seconde couche comporte un mélange de CuO de BaCuO₂ et de BaO ; et
le rapport du cuivre (Cu) au baryum (Ba) dans ladite seconde couche est situé dans la plage de Cu : Ba = 1 :0,10 à 0,95 en rapport molaire.

4. Le procédé tel que revendiqué dans la revendication 1 ou 2, dans lequel :
ladite seconde couche comporte un mélange de CuO, de BaCuO₂, de BaO, de Y₂O₃ et de YBa₂Cu₃O₇; et
le rapport du cuivre (Cu) au baryum (Ba) et à l'yttrium (Y) dans ladite seconde couche est situé dans la plage de Cu : Ba : Y = 1 : 0,10 à 0,95 : 0,001 à 0,330 en rapport molaire.
